# EUROPEAN PATENT APPLICATION

(11) **EP 4 636 447 A1**
(43) Date of publication of application: **22.10.2025**
(21) Application number: 23902663.6
(22) Date of filing: 11.12.2023
(51) Int. Cl.: G02B 6/12

(54) **PACKAGING STRUCTURE AND MANUFACTURING METHOD THEREFOR**

(30) Priority: 12.12.2022 CN 202211599845
(71) Applicant: Nanjing Guangzhiyuan Technology Co., Ltd., Nanjing, Jiangsu 211899 (CN)
(72) Inventor: MENG, Huaiyu, Nanjing, Jiangsu 211899 (CN); SHEN, Yichen, Nanjing, Jiangsu 211899 (CN); YAN, Qixin, Nanjing, Jiangsu 211899 (CN); JIANG, Lushan, Nanjing, Jiangsu 211899 (CN); WU, Jianhua, Nanjing, Jiangsu 211899 (CN)
(74) Representative: Nederlandsch Octrooibureau
(86) International application number: PCT/CN2023/137996
(87) International publication number: WO 2024/125467

(57) **Abstract**

Disclosed is a packaging structure and a manufacturing method therefor, including: stacking an optical coupler covering an optical coupling region on a side surface of a first semiconductor chip where the optical coupling region is disposed, wherein the optical coupler is configured to change the propagation direction of light and has a focusing effect, capable of coupling incident light to a corresponding optical coupling interface without insertion loss. This not only resolves the conflict between the requirements for coupling space and physical protection in a 3D stacked packaging structure but also achieves a higher optical alignment tolerance, which is beneficial for improving the operational efficiency of the surface coupling process and reducing coupling loss under the same alignment mismatch.

## Description

The present application claims priority to the Chinese patent application No. 202211599845.8 filed with the China Patent Office on December 12, 2022 and entitled "PACKAGING STRUCTURE AND MANUFACTURING METHOD THEREFOR," the entire contents of which are incorporated herein by reference.

### FIELD OF INVENTION

The present application relates to the field of semiconductor packaging, and in particular, to a packaging structure and a manufacturing method therefor.

### BACKGROUND OF INVENTION

With the continuous advancement of semiconductor technologies, packaging structures with high integration density have become increasingly important. For example, adopting a 3D packaging structure enables chip-to-chip stacking.

Currently, electronic integrated circuit chips (EIC chips) and photonic integrated circuit chips (PIC chips) in existing silicon photonic chips are manufactured by different wafer fabrication processes. Chip-level interconnections (such as wire bonding or flip-chip bonding) are used to achieve connections between the EIC chip and the PIC chip, forming a three-dimensional interconnection structure.

To shorten signal transmission paths and achieve sufficiently good electrical performance, the trend of replacing traditional wire bonding with 3D stacking interconnections for PIC chips and EIC chips is becoming increasingly prevalent. Meanwhile, when an optical fiber structure is coupled to a PIC chip by surface coupling to connect with a grating coupler (GC), it is necessary to reserve space for coupling, while ensuring that no organic residues remain on the coupling surface to obstruct light transmission. However, 3D stacking interconnections typically involve a molding process, where the surface of the PIC chip facing the EIC chip is entirely encapsulated by a plastic encapsulation layer to provide effective physical protection for both the EIC and PIC chips. This creates a conflict between the requirements for coupling space and physical protection. Additionally, the current mainstream surface coupling process involves first performing passive alignment to place the optical fiber structure within a certain range of the target position, followed by active alignment to read coupling efficiency data and determine the final position. This results in low operational efficiency for the entire surface coupling process. Moreover, in existing surface coupling structures, to control the coupling loss of the grating coupler within 1 dB, the placement accuracy of the placement equipment in the X-Y direction must be controlled within ±2.5 µm, which imposes higher demands on the placement accuracy of the equipment.

### SUMMARY OF INVENTION

### Technical Solution

The embodiments of the present application provide a packaging structure and a manufacturing method therefor.

In an exemplary embodiment, a packaging structure is provided, including:
a first semiconductor chip, wherein the first semiconductor chip includes a first surface and a second surface opposite each other, an optical coupling region is disposed on the first surface or the second surface, and an optical coupling interface is provided in the optical coupling region; and
an optical coupler, wherein the optical coupler is fixed on a side surface of the first semiconductor chip that includes the optical coupling region and correspondingly covers the optical coupling region, the optical coupler corrects external input light by modulating a distance between the optical coupler and the optical coupling interface to couple the external input light to the corresponding optical coupling interface.

In some embodiments, the optical coupler includes: a first substrate layer, and a first reflective lens unit and a second reflective lens unit respectively located on a side surface of the first substrate layer close to the first semiconductor chip and the side surface away from the first semiconductor chip, wherein the first substrate layer has light-transmissive properties for light of a predetermined wavelength; wherein the first reflective lens unit includes at least one first reflective lens, and the second reflective lens unit includes at least one second reflective lens; each first reflective lens is configured to reflect light of all wavelengths incident thereon, and each second reflective lens is configured to reflect light of all wavelengths incident thereon; the first reflective lens unit is positioned at a first lateral distance position having a first lateral distance from the optical coupling interface of the first semiconductor chip, and the second reflective lens unit is positioned at a second lateral distance position having a second lateral distance from the optical coupling interface of the first semiconductor chip.

In some embodiments, the second reflective lens unit is located on the side surface of the first substrate layer close to the first semiconductor chip, the first reflective lens unit is located on the side surface of the first substrate layer away from the first semiconductor chip, and the first lateral distance is less than the second lateral distance.

In some embodiments, the packaging structure further includes an optical fiber structure, the optical fiber structure is disposed on the side surface of the first substrate layer away from the first semiconductor chip, and the optical fiber structure is positioned at a third lateral distance position having a third lateral distance from the first reflective lens unit, and by modulating the first lateral distance, the second lateral distance, and the third lateral distance, the optical coupler causes light from the optical fiber structure to be sequentially reflected by the second reflective lens unit and the first reflective lens unit before entering the optical coupling interface.

In some embodiments, the light from the optical fiber structure is divergent light, the second reflective lens unit reflects the divergent light to form parallel light, and the first reflective lens unit reflects the parallel light to form a beam focused onto the optical coupling interface.

In some embodiments, each first reflective lens and each second reflective lens are composed of a lens structure formed on the first substrate layer and a reflective metal layer deposited on a surface of the lens structure.

In some embodiments, the first reflective lens and the second reflective lens have same size and shape.

In some embodiments, an optical coupling adhesive with a first thickness is filled between the optical coupler and the side surface of the first semiconductor chip that is provided with the optical coupling region; wherein, in a direction perpendicular to the first surface, the first thickness is greater than a cross-sectional height of the second reflective lens.

In some embodiments, the packaging structure further includes at least one second semiconductor chip, the at least one second semiconductor chip is fixed on the first surface of the first semiconductor chip.

In some embodiments, when the optical coupler and the at least one second semiconductor chip are simultaneously located on the first surface of the corresponding first semiconductor chip, and in the direction perpendicular to the first surface, the top surface of the optical coupler away from the first surface is flush with a top surface of the at least one second semiconductor chip away from the first surface.

In an exemplary embodiment, a packaging structure manufacturing method is provided, and the method includes:
providing a semiconductor wafer, wherein the semiconductor wafer includes a plurality of first semiconductor chips, each first semiconductor chip includes a first surface and a second surface opposite each other, an optical coupling region is disposed on the first surface or the second surface, and an optical coupling interface is provided in the optical coupling region; and
for each first semiconductor chip, providing an optical coupler corresponding to the first semiconductor chip, disposing the optical coupler on a side surface of the first semiconductor chip including the optical coupling region and correspondingly covering the optical coupling region, wherein the optical coupler corrects external input light by modulating a distance between the optical coupler and the optical coupling interface to couple the external input light to the corresponding optical coupling interface.

In some embodiments, for each first semiconductor chip, providing at least one second semiconductor chip corresponding to the first semiconductor chip, and fixing the at least one second semiconductor chip on the first surface of the first semiconductor chip.

In some embodiments, the optical coupler includes: a first substrate layer, and a first reflective lens unit and a second reflective lens unit respectively located on a side surface of the first substrate layer close to the first semiconductor chip and a side surface of the first substrate layer away from the first semiconductor chip, wherein the first substrate layer has light-transmissive properties for light of a predetermined wavelength; wherein the first reflective lens unit includes at least one first reflective lens, and the second reflective lens unit includes at least one second reflective lens; each first reflective lens is configured to reflect light of all wavelengths incident thereon, and each second reflective lens is configured to reflect light of all wavelengths incident thereon; the first reflective lens unit is positioned at a first lateral distance position having a first lateral distance from the optical coupling interface of the first semiconductor chip, and the second reflective lens unit is positioned at a second lateral distance position having a second lateral distance from the optical coupling interface of the first semiconductor chip.

In some embodiments, the second reflective lens unit is disposed on the side surface of the first substrate layer close to the first semiconductor chip, the first reflective lens unit is disposed on the side surface of the first substrate layer away from the first semiconductor chip, and the first lateral distance is less than the second lateral distance.

In some embodiments, an optical fiber structure is provided, and the optical fiber structure is fixed on the side surface of the first substrate layer away from the first semiconductor chip, and the optical fiber structure is positioned at a third lateral distance position having a third lateral distance from the first reflective lens unit, and by modulating the first lateral distance, the second lateral distance, and the third lateral distance, the optical coupler causes light from the optical fiber structure to be sequentially reflected by the second reflective lens unit and the first reflective lens unit before entering the optical coupling interface.

In some embodiments, the first reflective lens and the second reflective lens have same size and shape.

In some embodiments, the step of disposing the optical coupler corresponding to each first semiconductor chip on the side surface of the first semiconductor chip including the optical coupling region includes: fixing each optical coupler to the side surface of the first semiconductor chip including the optical coupling region by an optical coupling adhesive; wherein the optical coupling adhesive includes a first thickness, and in a direction perpendicular to the first surface, the first thickness is greater than a cross-sectional height of the second reflective lens.

In some embodiments, the semiconductor wafer includes a first carrier substrate, the first carrier substrate is temporarily bonded to the second surfaces of the plurality of first semiconductor chips to temporarily support the semiconductor wafer.

In some embodiments, after fixing the optical coupler corresponding to each first semiconductor chip on the first semiconductor chip, the method includes: forming a plastic encapsulation layer, wherein for each first semiconductor chip, the plastic encapsulation layer encapsulates side surfaces of the optical coupler and covers remains of the first surface and exposes a side surface of the optical coupler away from the first semiconductor chip.

In some embodiments, the method of forming the plastic encapsulation layer includes: for a case where the optical coupler and at least one second semiconductor chip are simultaneously fixed on the first surface of the corresponding first semiconductor chip, attaching a release film to the side surfaces of the optical coupler and the at least one second semiconductor chip away from the first semiconductor chip; forming at least one opening through a thickness of the release film on a side of the release film away from the optical coupler and the at least one second semiconductor chip, and injecting a gel-like plastic encapsulation material into the opening to form the plastic encapsulation layer; wherein a position of the at least one opening corresponds to a gap between adjacent two of the second semiconductor chips and/or a gap between each second semiconductor chip and the optical coupler.

In some embodiments, after the plastic encapsulation layer is formed, the method includes: removing the release film; attaching the side surfaces of each second semiconductor chip and each optical coupler away from the corresponding first semiconductor chip to a dicing tape, and then debonding the first carrier substrate.

In some embodiments, a method for manufacturing the optical coupler includes:
providing a first substrate including a first substrate layer, wherein the first substrate includes a first side and a second side opposite each other;
forming a first photoresist layer on a first side of the first substrate;
performing patterned photolithography etching on the first photoresist layer by a mask process to form a first arc-shaped protrusion structure from remains of the first photoresist layer;
etching the first arc-shaped protrusion structure by an etching process to form a first lens structure on one side of the first substrate layer;
depositing a reflective metal layer on an exposed surface of the first lens structure to form the first reflective lens;
forming a second photoresist layer on the second side of the first substrate;
performing patterned photolithography etching on the second photoresist layer by a mask process to form a second arc-shaped protrusion structure from remains of the second photoresist layer;
etching the second arc-shaped protrusion structure by an etching process to form a second lens structure on another side of the first substrate layer; and
depositing a reflective metal layer on an exposed surface of the second lens structure to form the second reflective lens.

The embodiments of the present invention provide a solution for a packaging structure and a manufacturing method therefor, aiming to address the conflict between the requirements for coupling space and physical protection in a 3D stacked packaging structure without affecting the surface coupling method used for optical coupling between the optical fiber structure and the photonic integrated circuit chip (PIC chip), as well as to improve the operational efficiency of the surface coupling process.

Various aspects, features, advantages, and other details of the embodiments of the present invention will be described in detail below with reference to the accompanying drawings. The above aspects, features, advantages, and other details of the present invention will become clearer from the detailed description below in conjunction with the drawings.

With reference to the following description and drawings, specific embodiments of the present invention are disclosed in detail, indicating the ways in which the principles of the present invention may be implemented. It should be understood that the embodiments of the present invention are not limited in scope thereby. Within the spirit and scope of the appended claims, the embodiments of the present invention include many changes, modifications, and equivalents.

Features described and/or illustrated with respect to one embodiment may be used in the same or similar manner in one or more other embodiments, combined with features in other embodiments, or substituted for features in other embodiments.

It should be emphasized that the term "including/comprising" as used herein refers to the presence of features, components, steps, or assemblies but does not preclude the presence or addition of one or more other features, components, steps, or assemblies.

### DESCRIPTION OF DRAWINGS

To more clearly illustrate the technical solutions in the embodiments of the present application, the drawings used in the description of the embodiments are briefly introduced below. It is obvious that the drawings described below are only some embodiments of the present application, and for those skilled in the art, other drawings can be obtained based on these drawings without creative effort.
FIG. 1 is a schematic view of a chip-level packaging structure provided according to an embodiment of the present invention.
FIG. 2 is a schematic view of a planar structure of a first semiconductor chip provided in FIG. 1.
FIG. 3 is a side view of a first reflective lens unit provided in FIG. 1.
FIG. 4 is a side view of a second reflective lens unit provided in FIG. 1.
FIG. 5A is a schematic view of connection between the chip-level packaging structure provided in FIG. 1 and a packaging substrate.
FIG. 5B is another schematic view of connection between the chip-level packaging structure provided in FIG. 1 and a packaging substrate.
FIG. 6 is a flowchart of a packaging structure manufacturing method provided according to an embodiment of the present invention.
FIGs. 7A-7G are schematic views of manufacturing steps of the packaging structure manufacturing method provided according to an embodiment of the present invention.

### DETAILED DESCRIPTION OF PREFERRED EMBODIMENTS

The above description is merely an overview of the technical solution of the present invention. To better understand the technical means of the present invention and enable implementation according to the content of the specification, and to make the above and other objectives, features, and advantages of the present invention more apparent and understandable, preferred embodiments are specifically cited below and described in detail with reference to the accompanying drawings.

In the description of the present invention, it should be noted that unless otherwise explicitly specified and limited, the terms "mounted," "connected," and "connection" should be understood in a broad sense. For example, they may refer to fixed connections, detachable connections, or integral connections; they may refer to mechanical connections, electrical connections, or connections capable of mutual communication; they may refer to direct connections or indirect connections through an intermediate medium, or internal communication between two components or the interaction relationship between two components. The term "chip" herein may include bare chips. When referring to method steps, the sequence shown in the figures represents an exemplary solution but does not imply a limitation on the sequence. For those skilled in the art, the specific meanings of the above terms in the present invention can be understood based on specific circumstances.

To make the objectives, features, and advantages of the present invention more apparent and understandable, the present invention is further described in detail below with reference to the accompanying drawings and specific embodiments.

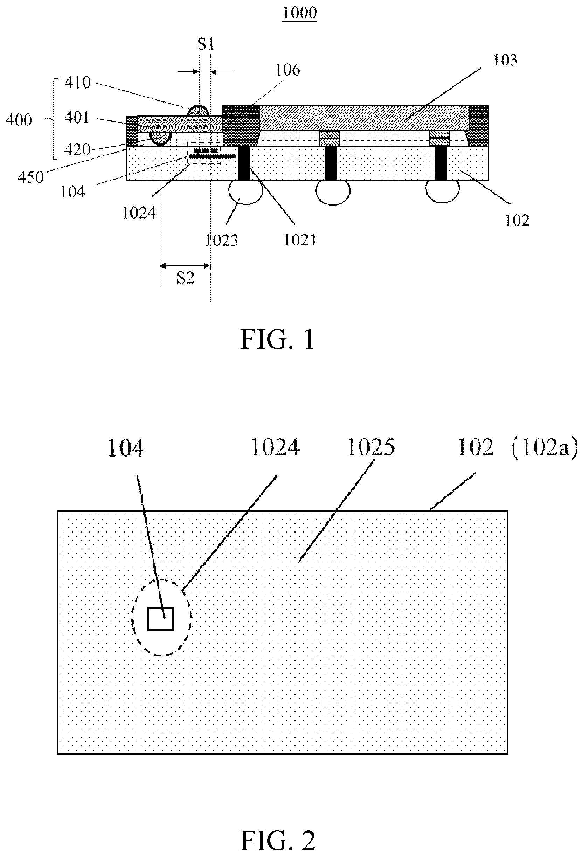

FIG. 1 is a schematic view of a chip-level packaging structure provided according to an embodiment of the present invention. FIG. 2 is a schematic view of the planar structure of the first semiconductor chip provided in FIG. 1.

Exemplarily, as shown in FIGs. 1 and 2, the packaging structure 1000 includes: a first semiconductor chip 102, wherein the first semiconductor chip 102 includes a first surface 102a and a second surface 102b opposite each other, an optical coupling region 1024 is disposed on the first surface 102a, and an optical coupling interface 104 is provided in the optical coupling region 1024; an optical coupler 400, wherein the optical coupler 400 is fixed on a side surface of the first semiconductor chip 102 including the optical coupling region 1024 and correspondingly covers the optical coupling region 1024, and the optical coupler 400 corrects external input light by modulating a distance between the optical coupler 400 and the optical coupling interface 104 to couple the external input light to the corresponding optical coupling interface 104.

In the embodiments of the present invention, exemplarily, the first semiconductor chip 102 is a photonic integrated circuit chip (PIC chip), wherein the photonic integrated circuit chip processes and transmits information using photons as the information carrier, and it may be a silicon-based photonic integrated circuit chip.

It should be noted that in the embodiments of the present invention, the optical coupling region 1024 may be disposed on either the first surface 102a or the second surface 102b of the first semiconductor chip 102. Accordingly, the optical coupler 400 is placed adjacent to the first surface 102a of the first semiconductor chip 102 and correspondingly covers the optical coupling region 1024; or the optical coupler 400 is placed adjacent to the second surface 102b of the first semiconductor chip 102 and correspondingly covers the optical coupling region 1024. The technical solution proposed in the embodiments of the present invention involves stacking an optical coupler covering the optical coupling region on the side surface of the first semiconductor chip where the optical coupling region is disposed, wherein the optical coupler is configured to change a propagation direction of light and has a focusing effect, capable of coupling the incident light to the corresponding optical coupling interface without insertion loss. This not only resolves the conflict between the requirements for coupling space and physical protection in a 3D stacked packaging structure but also achieves a higher optical alignment tolerance, which is beneficial for improving the operational efficiency of the surface coupling process and reducing coupling loss under the same alignment mismatch.

It should be understood that the aforementioned modulation of the distance between the optical coupler 400 and the optical coupling interface 104 may refer to a three-dimensional spatial distance, for example, including an X-direction distance and/or a Y-direction distance and/or a Z-direction distance.

Exemplarily, the optical coupler 400 in the embodiments of the present invention includes: a first substrate layer 401, and a first reflective lens unit 410 and a second reflective lens unit 420 respectively located on a side surface of the first substrate layer 401 close to the first semiconductor chip 102 and a side surface of the first substrate layer 401 away from the first semiconductor chip 102, wherein the first substrate layer 401 has light-transmissive properties for light of a predetermined wavelength.

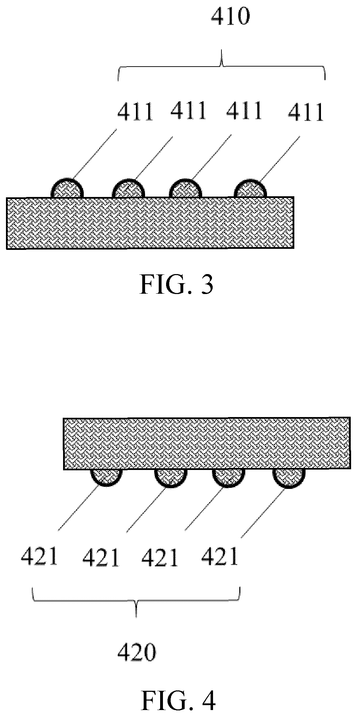

As shown in FIGs. 3 and 4, the first reflective lens unit 410 includes at least one first reflective lens 411, and the second reflective lens unit 420 includes at least one second reflective lens 421; each first reflective lens 411 is configured to reflect light of all wavelengths incident thereon, and each second reflective lens 421 is configured to reflect light of all wavelengths incident thereon; the first reflective lens unit 410 is positioned at a first lateral distance position having a first lateral distance S1 from the optical coupling interface 104 of the first semiconductor chip 102, and the second reflective lens unit 420 is positioned at a second lateral distance position having a second lateral distance S2 from the optical coupling interface 104 of the first semiconductor chip 102.

It should be noted that in the embodiments of the present invention, when the first reflective lens unit 410 includes multiple first reflective lenses 411, the multiple first reflective lenses 411 may be arranged side by side to guide light from multiple optical fiber structures into the optical coupling interface 104 of the first semiconductor chip 102; when the second reflective lens unit 420 includes multiple second reflective lenses 421, the multiple second reflective lenses 421 may be arranged side by side to guide light from multiple optical fiber structures into the optical coupling interface 104 of the first semiconductor chip 102.

In the embodiments of the present invention, by constructing an optical coupler 400 that changes the propagation direction of light and has a focusing effect as a light corrector in optical coupling, and by configuring the first substrate layer 401 of the optical coupler 400 to be transparent to light of a predetermined wavelength, for example, by selecting silicon or glass to construct the first substrate layer 401, the optical coupler 400 not only provides a certain degree of physical protection to the optical coupling region 1024 after covering it but also achieves a higher optical alignment tolerance, which is beneficial for improving the operational efficiency of the surface coupling process and reducing coupling loss under the same alignment mismatch. For example, when controlling insertion loss to 1 dB, the technical solution provided by the embodiments of the present invention allows the optical alignment tolerance of the surface coupling structure to reach ±25 µm, whereas the optical alignment tolerance of conventional surface coupling structures is only ±2.5 µm. Therefore, the technical solution provided by the embodiments of the present invention has a higher tolerance for placement alignment errors of placement equipment.

Exemplarily, in the embodiments of the present invention, the second reflective lens unit 420 is located on the side surface of the first substrate layer 401 close to the first semiconductor chip 102, the first reflective lens unit 410 is located on the side surface of the first substrate layer 401 away from the first semiconductor chip 102, and the first lateral distance S1 is less than the second lateral distance S2.

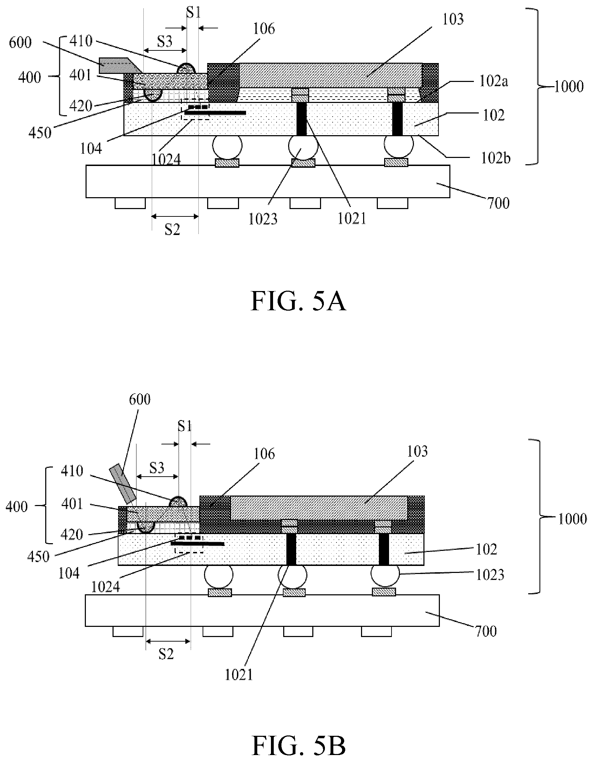

FIG. 5A is a schematic view of the connection between the chip-level packaging structure provided in FIG. 1 and a packaging substrate. FIG. 5B is another schematic view of connection between the chip-level packaging structure provided in FIG. 1 and a packaging substrate.

Exemplarily, as shown in FIG. 5A, the packaging structure further includes an optical fiber structure 600, the optical fiber structure 600 is disposed on the side surface of the first substrate layer 401 away from the first semiconductor chip 102, and the optical fiber structure 600 is positioned at a third lateral distance position having a third lateral distance S3 from the first reflective lens unit 410. By modulating the first lateral distance S1, the second lateral distance S2, and the third lateral distance S3, the optical coupler 400 causes light from the optical fiber structure 600 to be sequentially reflected by the second reflective lens unit 420 and the first reflective lens unit 410 before entering the optical coupling interface 104.

In this embodiment, one side end of the optical fiber structure 600 may include an inclined surface with a predetermined angle relative to its main body, for example, the predetermined angle being 45°; the main body of the optical fiber structure 600 is laid flat and mounted on the side surface of the first substrate layer 401 away from the first semiconductor chip 102, so that the light transmitted within the optical fiber structure 600 undergoes total reflection at the inclined surface of the end and sequentially enters the first substrate layer 401 and is incident on the second reflective lens unit 420.

Optionally, as shown in FIG. 5B, in some other embodiments, one side end of the optical fiber structure 600 may also be a plane with a 90° angle relative to its main body, and the main body of the optical fiber structure 600 is mounted at an incline on the side surface of the first substrate layer 401 away from the first semiconductor chip 102, so that the light transmitted within the optical fiber structure 600 can directly enter the first substrate layer 401 and be incident on the second reflective lens unit 420. Specifically, the optical fiber structure 600 is positioned at a third lateral distance position having a third lateral distance S3 from the first reflective lens unit 410, and by modulating the first lateral distance S1, the second lateral distance S2, and the third lateral distance S3, the optical coupler 400 causes light from the optical fiber structure 600 to be sequentially reflected by the second reflective lens unit 420 and the first reflective lens unit 410 before entering the optical coupling interface 104.

Exemplarily, for example, the light from the optical fiber structure 600 is divergent light, the second reflective lens unit 420 reflects the divergent light to form parallel light, and the first reflective lens unit 410 reflects the parallel light to form a beam focused onto the optical coupling interface 104.

Further, in the embodiments of the present invention, each first reflective lens 411 and each second reflective lens 421 are composed of a lens structure formed on the first substrate layer 401 and a reflective metal layer deposited on a surface of the lens structure.

Further, to facilitate optical path design and manufacturing, in the embodiments of the present invention, the first reflective lens 411 and the second reflective lens 421 have the same size and shape.

Further, as shown in FIG. 1, an optical coupling adhesive 450 with a first thickness is filled between the optical coupler 400 and the side surface of the first semiconductor chip 102 that is provided with the optical coupling region 1024; wherein, in a direction perpendicular to the first surface 102a, the first thickness is greater than a cross-sectional height of the second reflective lens 421.

It should be noted that the optical coupling adhesive 450 is light-transmissive, for example, having a transmittance greater than 90%, preferably greater than 98%, thus allowing light from an external light source to be input to the optical coupling interface 104 with minimal loss. The optical coupling adhesive 450 also enables the optical coupler 400 to be securely fixed to the side surface of the first semiconductor chip 102. Additionally, in the direction perpendicular to the first surface 102a, the first thickness being greater than the cross-sectional height of the second reflective lens 421 ensures that the plane of the first substrate layer 401 of the optical coupler 400 is parallel to the first surface 102a of the first semiconductor chip 102, thereby facilitating optical path design and transmission.

Optionally, in some embodiments, the packaging structure further includes at least one second semiconductor chip 103, and the at least one second semiconductor chip 103 is fixed on the first surface 102a of the first semiconductor chip 102.

In the embodiments of the present invention, exemplarily, the second semiconductor chip 103 is an electronic integrated circuit chip (EIC chip), wherein the electronic integrated circuit chip processes and transmits information using electrons as the information carrier, such as a silicon-based electronic integrated circuit chip, a germanium-based electronic integrated circuit chip, or a compound semiconductor electronic integrated circuit chip. By stacking the first semiconductor chip 102 and the second semiconductor chip 103, integration of the photonic integrated circuit chip and the electronic integrated circuit chip can be achieved.

Optionally, in some other embodiments, the packaging structure may include only the optical coupler 400 disposed on one side surface of the first semiconductor chip 102, that is, no second semiconductor chip 103 is disposed on the side surface of the first semiconductor chip 102.

Further, when the optical coupler 400 and the at least one second semiconductor chip 103 are simultaneously located on the first surface 102a of the corresponding first semiconductor chip 102, in the direction perpendicular to the first surface 102a, the top surface of the optical coupler 400 away from the first surface 102a is flush with a top surface of the at least one second semiconductor chip 103 away from the first surface 102a. That is, the packaged at least one second semiconductor chip 103 and the optical coupler 400 have the same height, resulting in a flat, damage-resistant, and highly reliable surface for the 3D chip stacking packaging structure.

Optionally, in some embodiments, to enhance packaging strength, the packaging structure further includes a plastic encapsulation layer 106, the plastic encapsulation layer encapsulating the side surfaces of the optical coupler 400 and/or the at least one second semiconductor chip 103, while exposing the side surfaces of the optical coupler 400 and/or the at least one second semiconductor chip 103 away from the first semiconductor chip 102.

According to another aspect of the present invention, a packaging structure manufacturing method is also provided.

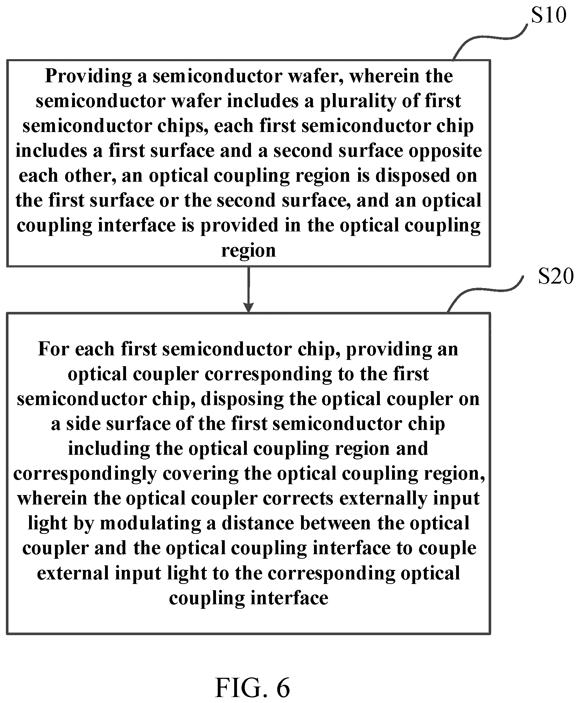

FIG. 6 is a flowchart of a packaging structure manufacturing method provided according to an embodiment of the present invention.

As shown in FIG. 6, the packaging structure manufacturing method includes steps as follows:
Step S10: Providing a semiconductor wafer, wherein the semiconductor wafer includes a plurality of first semiconductor chips, each first semiconductor chip includes a first surface and a second surface opposite each other, an optical coupling region is disposed on the first surface or the second surface, and an optical coupling interface is provided in the optical coupling region; and
Step S20: For each first semiconductor chip, providing an optical coupler corresponding to the first semiconductor chip, disposing the optical coupler on a side surface of the first semiconductor chip including the optical coupling region and correspondingly covering the optical coupling region, wherein the optical coupler corrects external input light by modulating a distance between the optical coupler and the optical coupling interface to couple the external input light to the corresponding optical coupling interface.

The embodiments of the present invention provide a packaging structure manufacturing method, aiming to address the conflict between the requirements for coupling space and physical protection in a 3D stacked packaging structure without affecting the surface coupling method used for optical coupling between the optical fiber structure and the photonic integrated circuit chip (PIC chip). For each first semiconductor chip, an optical coupler covering the optical coupling region is stacked on the side surface of the first semiconductor chip where the optical coupling region is disposed. The optical coupler is used to change the propagation direction of light and has a focusing effect, capable of coupling the incident light to the corresponding optical coupling interface without insertion loss, achieving a higher optical alignment tolerance, which is beneficial for improving the operational efficiency of the surface coupling process and reducing coupling loss under the same alignment mismatch.

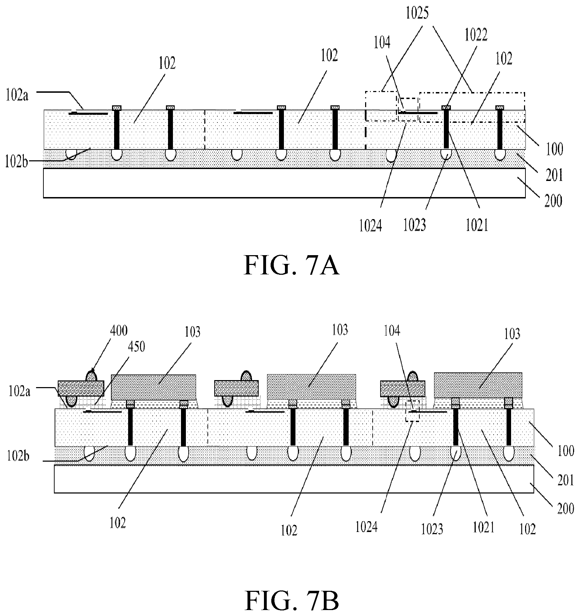

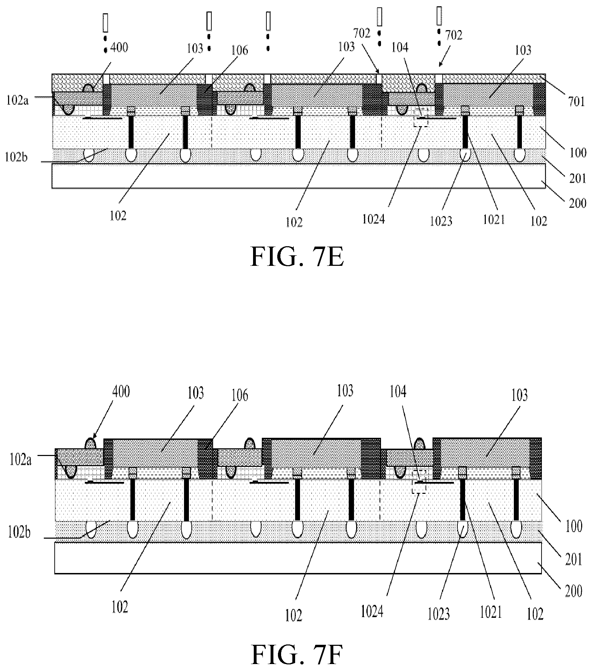

FIGs. 7A-7G are schematic views of the manufacturing steps of a packaging structure manufacturing method provided according to an embodiment of the present invention.

The embodiments of the present invention are described in detail below with reference to FIGs. 7A-7G, FIGs. 1-2, FIGs. 3-4, FIGs. 5A-5B, and FIG. 6.

Exemplarily, in this embodiment, as shown in FIG. 7A, a semiconductor wafer 100 is first provided, the semiconductor wafer 100 includes a plurality of first semiconductor chips 102, and each first semiconductor chip 102 includes a first surface 102a and a second surface 102b opposite each other.

Optionally, in some embodiments, to avoid warping issues with the first semiconductor chip 102 after thinning, which could lead to misalignment or failure of connection points between the second semiconductor chip 103 and the first semiconductor chip 102, as shown in FIG. 7A, the semiconductor wafer 100 further includes a first carrier substrate 200, the first carrier substrate 200 is temporarily bonded to the second surfaces 102b of the plurality of first semiconductor chips 102 via a bonding adhesive 201 to temporarily support the semiconductor wafer 100.

Optionally, in some other embodiments, the semiconductor wafer 100 may not include the first carrier substrate 200, and the subsequent manufacturing of the packaging structure may be performed directly on one side surface of the semiconductor wafer 100 composed of multiple first semiconductor chips 102.

Continuing to refer to FIGs. 1-2, exemplarily, an optical coupling region 1024 and a non-optical coupling region 1025 surrounding the optical coupling region 1024 are disposed on the first surface 102a or the second surface 102b of the first semiconductor chip 102, and an optical coupling interface 104 is provided in the optical coupling region 1024. Light from an external light source can be input to the optical coupling interface 104 through an optical fiber structure, for example, by coupling with a grating coupler within the optical coupling interface 104 into the first semiconductor chip 102. It should be noted that in other embodiments, other optical interconnection interfaces or devices for transmitting optical signals may also be correspondingly disposed within the optical coupling interface 104.

For each first semiconductor chip 102, an optical coupler 400 corresponding to the first semiconductor chip 102 is provided, the optical coupler 400 is disposed on the side surface of the first semiconductor chip 102 including the optical coupling region 1024 and correspondingly covers the optical coupling region 1024, and the optical coupler 400 corrects external input light by modulating the distance between the optical coupler 400 and the optical coupling interface 104 to couple the external input light to the corresponding optical coupling interface 104.

It should be noted that in the embodiments of the present invention, the optical coupling region 1024 may be disposed on either the first surface 102a or the second surface 102b of the first semiconductor chip 102. Accordingly, the optical coupler 400 is placed adjacent to the first surface 102a of the first semiconductor chip 102 and correspondingly covers the optical coupling region 1024; or the optical coupler 400 is placed adjacent to the second surface 102b of the first semiconductor chip 102 and correspondingly covers the optical coupling region 1024.

As shown in FIG. 7B, in some embodiments, the packaging structure manufacturing method further includes: providing at least one second semiconductor chip 103 corresponding to the first semiconductor chip 102, and fixing the at least one second semiconductor chip 103 on the first surface 102a of the first semiconductor chip 102.

It should be understood that in some other embodiments, the packaging structure manufacturing method may include only disposing the optical coupler 400 on one side surface of the first semiconductor chip 102, that is, no second semiconductor chip 103 is disposed on the side surface of the first semiconductor chip 102.

Further, fixing the at least one second semiconductor chip and the optical coupler on the first semiconductor chip includes: fixing the at least one second semiconductor chip 103 on the first surface 102a of the first semiconductor chip 102 by thermal compression bonding (TCB), reflow soldering, or hybrid bonding. Exemplarily, in this embodiment, the second semiconductor chip 103 is bonded to the first semiconductor chip 102 by flip-chip bonding. Optionally, underfill is filled in a gap between each second semiconductor chip 103 and the first surface 102a to further reinforce each second semiconductor chip 103.

Specifically, the method of fixing the optical coupler 400 corresponding to each first semiconductor chip 102 on the side surface of the first semiconductor chip 102 including the optical coupling region 1024 includes: fixing the optical coupler 400 to the side surface of the first semiconductor chip 102 including the optical coupling region by an optical coupling adhesive 450, wherein the optical coupling adhesive has a first thickness, and in a direction perpendicular to the first surface 102a, and the first thickness is greater than the cross-sectional height of the second reflective lens 421, ensuring that the plane of the first substrate layer 401 of the optical coupler 400 is parallel to the first surface 102a of the first semiconductor chip 102, thereby facilitating optical path design and transmission. It should be noted that the optical coupling adhesive 450 is light-transmissive, for example, having a transmittance greater than 90%, preferably greater than 98%, thus allowing light from an external light source to be input to the optical coupling interface 104 with minimal loss.

Exemplarily, the optical coupler 400 in the embodiments of the present invention includes: a first substrate layer 401, and a first reflective lens unit 410 and a second reflective lens unit 420 respectively located on the side surface of the first substrate layer 401 close to the first semiconductor chip 102 and the side surface away from the first semiconductor chip 102, wherein the first substrate layer 401 has light-transmissive properties for light of a predetermined wavelength; wherein, as shown in FIGs. 3 and 4, the first reflective lens unit 410 includes at least one first reflective lens 411, and the second reflective lens unit 420 includes at least one second reflective lens 421; each first reflective lens 411 is configured to reflect light of all wavelengths incident thereon, and each second reflective lens 421 is configured to reflect light of all wavelengths incident thereon; the first reflective lens unit 410 is positioned at a first lateral distance position having a first lateral distance from the optical coupling interface 104 of the first semiconductor chip 102, and the second reflective lens unit 420 is positioned at a second lateral distance position having a second lateral distance from the optical coupling interface 104 of the first semiconductor chip 102.

In the embodiments of the present invention, by constructing an optical coupler 400 that changes the propagation direction of light and has a focusing effect as a light corrector in optical coupling, and by configuring the first substrate layer 401 of the optical coupler 400 to be transparent to light of a predetermined wavelength, for example, by selecting pure silicon or glass to construct the first substrate layer 401, the optical coupler 400 not only provides a certain degree of physical protection to the optical coupling region 1024 after covering it but also achieves a higher optical alignment tolerance, which is beneficial for improving the operational efficiency of the surface coupling process and reducing coupling loss under the same alignment mismatch. For example, when controlling insertion loss to 1 dB, the technical solution provided by the embodiments of the present invention allows the optical alignment tolerance of the surface coupling structure to reach ±25 µm, whereas the optical alignment tolerance of conventional surface coupling structures is only ±2.5 µm. Therefore, the technical solution provided by the embodiments of the present invention has a higher tolerance for placement alignment errors of placement equipment.

Exemplarily, in the embodiments of the present invention, the second reflective lens unit 420 is disposed on the side surface of the first substrate layer 401 close to the first semiconductor chip 102, the first reflective lens unit 410 is disposed on the side surface of the first substrate layer 401 away from the first semiconductor chip 102, and the first lateral distance is less than the second lateral distance.

Exemplarily, as shown in FIGs. 5A-5B, the packaging structure manufacturing method further includes: providing an optical fiber structure 600, and fixing the optical fiber structure 600 on the side surface of the first substrate layer 401 away from the first semiconductor chip 102, wherein the optical fiber structure 600 is positioned at a third lateral distance position having a third lateral distance from the first reflective lens unit 410. By modulating the first lateral distance, the second lateral distance, and the third lateral distance, the optical coupler 400 causes light from the optical fiber structure 600 to be sequentially reflected by the second reflective lens unit and the first reflective lens unit before entering the optical coupling interface 104.

Optionally, as shown in FIG. 5A, in some embodiments, one side end of the optical fiber structure 600 may include an inclined surface with a predetermined angle relative to its main body, for example, the predetermined angle being 45°; the main body of the optical fiber structure 600 is laid flat and mounted on the side surface of the first substrate layer 401 away from the first semiconductor chip 102, so that the light transmitted within the optical fiber structure 600 undergoes total reflection at the inclined surface of the end and sequentially enters the first substrate layer 401 and is incident on the first reflective lens unit 410.

Optionally, as shown in FIG. 5B, in some embodiments, one side end of the optical fiber structure 600 may also be a plane with a 90° angle relative to its main body, and the main body of the optical fiber structure 600 is mounted at an incline on the side surface of the first substrate layer 401 away from the first semiconductor chip 102, so that the light transmitted within the optical fiber structure 600 can directly enter the first substrate layer 401 and be incident on the first reflective lens unit 410.

Further, to facilitate optical path design and manufacturing, in the embodiments of the present invention, the first reflective lens 411 and the second reflective lens 421 have the same size and shape.

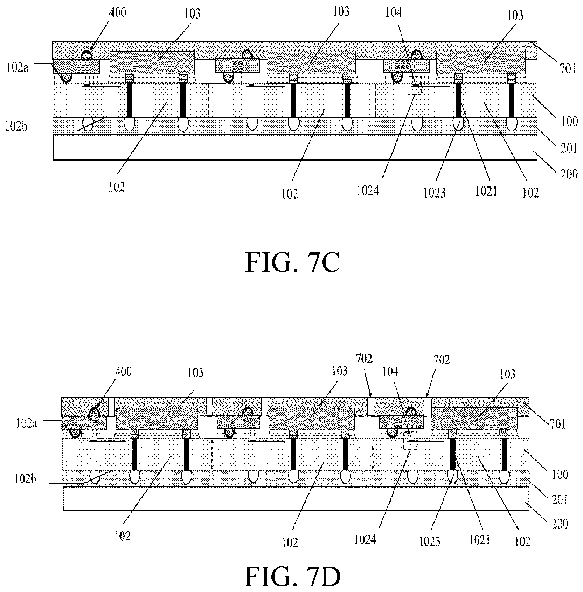

Exemplarily, in some embodiments, as shown in FIGs. 7C-7F, after fixing the optical coupler corresponding to each first semiconductor chip and the corresponding first semiconductor chip on the first semiconductor chip, a plastic encapsulation layer 106 is formed to enhance the overall packaging strength. For each first semiconductor chip 102, the plastic encapsulation layer 106 encapsulates side surfaces of the optical coupler 400 and the at least one second semiconductor chip 103 and covers remains of the first surface 102a, while exposing the side surfaces of each optical coupler 400 and each second semiconductor chip 103 away from the first semiconductor chip 102.

It should be understood that in some other embodiments, if no second semiconductor chip is formed on the first semiconductor chip, after fixing the optical coupler corresponding to each first semiconductor chip on the first semiconductor chip, the method includes: forming a plastic encapsulation layer 106 to enhance the overall packaging strength. For each first semiconductor chip 102, the plastic encapsulation layer 106 encapsulates side surfaces of the optical coupler 400 and covers remains of the first surface 102a, while exposing the side surface of each optical coupler 400 away from the first semiconductor chip 102.

As shown in FIGs. 7D-7E, the method of forming the plastic encapsulation layer includes: for a case where the optical coupler 400 and at least one second semiconductor chip 103 are simultaneously fixed on the first surface 102a of the corresponding first semiconductor chip 102, attaching a release film 701 to the side surfaces of the optical coupler 400 and the at least one second semiconductor chip 103 away from the first semiconductor chip 102; forming at least one opening 702 through a thickness of the release film 701 on a side of the release film 701 away from the optical coupler 400 and the at least one second semiconductor chip 103, and injecting a gel-like plastic encapsulation material into the opening 702 to form the plastic encapsulation layer 106; wherein a position of the at least one opening 702 corresponds to a gap between adjacent two of the second semiconductor chips 103 and/or a gap between each second semiconductor chip 103 and the optical coupler 400. Using the above step for forming the plastic encapsulation layer prevents the plastic encapsulation layer 106 from contaminating the surface of the optical coupler 400, which could lead to unnecessary light loss.

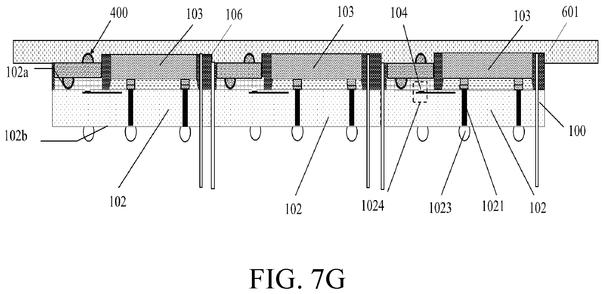

As shown in FIG. 7G, after the plastic encapsulation layer is formed, the method includes: removing the release film 701; attaching the side surfaces of each second semiconductor chip 103 and each optical coupler 400 away from the corresponding first semiconductor chip 102 to a dicing tape 601, and then debonding the first carrier substrate 200.

Further, the method further includes: after debonding the first carrier substrate 200, for the corresponding region boundary of each first semiconductor chip 102 on the semiconductor wafer 100, dicing the semiconductor wafer 100 from the second surface 102b toward the first surface 102a; and removing the dicing tape 601 to obtain multiple separated chip packaging assemblies, wherein each chip packaging assembly includes one first semiconductor chip, at least one corresponding second semiconductor chip, and a corresponding optical coupler.

It should be understood that in this embodiment, the dicing tape 601 can be used to buffer the cutting stress on the optical coupler 400 during dicing and can protect the first reflective lens unit 410 and the second reflective lens unit 420 from being scratched during the dicing process.

Specifically, as shown in FIG. 1, each chip packaging assembly includes one first semiconductor chip 102, a corresponding optical coupler 400, and at least one second semiconductor chip 103. It should be understood that the embodiment shown in FIG. 1 or FIG. 3 only illustrates one second semiconductor chip 103 formed above the first semiconductor chip 102. In actual use, there may be more than one second semiconductor chip 103, such as 2, 3, 4, or more, which can be flexibly selected based on actual needs.

Further, as shown in FIGs. 5A-5B, the method further includes: after obtaining multiple separated chip packaging assemblies, mounting each chip packaging assembly onto a corresponding substrate 700; and then mounting the optical fiber structure 600 onto the corresponding region of the optical coupler 400.

Exemplarily, in the embodiments of the present invention, a method for manufacturing the optical coupler 400 includes:
providing a first substrate including a first substrate layer, wherein the first substrate includes a first side and a second side opposite each other;
forming a first photoresist layer on a first side of the first substrate;
performing patterned photolithography etching on the first photoresist layer by a mask process to form a first arc-shaped protrusion structure from remains of the first photoresist layer;
etching the first arc-shaped protrusion structure by an etching process to form a first lens structure on one side of the first substrate layer;
depositing a reflective metal layer on an exposed surface of the first lens structure to form the first reflective lens;
forming a second photoresist layer on the second side of the first substrate;
performing patterned photolithography etching on the second photoresist layer by a mask process to form a second arc-shaped protrusion structure from remains of the second photoresist layer;
etching the second arc-shaped protrusion structure by an etching process to form a second lens structure on another side of the first substrate layer; and
depositing a reflective metal layer on an exposed surface of the second lens structure to form the second reflective lens.
from the above, it can be seen that the packaging structure and the manufacturing method therefor provided by the embodiments of the present invention aim to address the conflict between the requirements for coupling space and physical protection in a 3D stacked packaging structure without affecting the surface coupling method used for optical coupling between the optical fiber structure and the photonic integrated circuit chip (PIC chip), as well as to improve the operational efficiency of the surface coupling process and reduce coupling loss under the same alignment mismatch.

Those skilled in the art should understand that the above disclosure is merely embodiments of the present invention and does not limit the scope of the patent protection claimed by the present invention. Equivalent changes made based on the embodiments of the present invention still fall within the scope covered by the claims of the present invention.

## Claims

1. A packaging structure, comprising:
a first semiconductor chip, wherein the first semiconductor chip comprises a first surface and a second surface opposite each other, an optical coupling region is disposed on the first surface or the second surface, and an optical coupling interface is provided in the optical coupling region; and
an optical coupler, wherein the optical coupler is fixed on a side surface of the first semiconductor chip comprising the optical coupling region and correspondingly covers the optical coupling region, and the optical coupler corrects external input light by modulating a distance between the optical coupler and the optical coupling interface to couple the external input light to the corresponding optical coupling interface.

2. The packaging structure according to claim 1, wherein the optical coupler comprises:
a first substrate layer, and a first reflective lens unit and a second reflective lens unit respectively located on a side surface of the first substrate layer close to the first semiconductor chip and a side surface of the first substrate layer away from the first semiconductor chip, wherein the first substrate layer has light-transmissive properties for light of a predetermined wavelength;
wherein the first reflective lens unit comprises at least one first reflective lens, and the second reflective lens unit comprises at least one second reflective lens; each first reflective lens is configured to reflect light of all wavelengths incident thereon, and each second reflective lens is configured to reflect light of all wavelengths incident thereon;
the first reflective lens unit is positioned at a first lateral distance position having a first lateral distance from the optical coupling interface of the first semiconductor chip, and the second reflective lens unit is positioned at a second lateral distance position having a second lateral distance from the optical coupling interface of the first semiconductor chip.

3. The packaging structure according to claim 2, wherein the second reflective lens unit is located on the side surface of the first substrate layer close to the first semiconductor chip, the first reflective lens unit is located on the side surface of the first substrate layer away from the first semiconductor chip, and the first lateral distance is less than the second lateral distance.

4. The packaging structure according to claim 3, wherein the packaging structure further comprises an optical fiber structure, the optical fiber structure is disposed on the side surface of the first substrate layer away from the first semiconductor chip, and the optical fiber structure is positioned at a third lateral distance position having a third lateral distance from the first reflective lens unit, and by modulating the first lateral distance, the second lateral distance, and the third lateral distance, the optical coupler causes light from the optical fiber structure to be sequentially reflected by the second reflective lens unit and the first reflective lens unit before entering the optical coupling interface.

5. The packaging structure according to claim 1, wherein the light from the optical fiber structure is divergent light, the second reflective lens unit reflects the divergent light to form parallel light, and the first reflective lens unit reflects the parallel light to form a beam focused onto the optical coupling interface.

6. The packaging structure according to claim 2, wherein each first reflective lens and each second reflective lens are composed of a lens structure formed on the first substrate layer and a reflective metal layer deposited on a surface of the lens structure.

7. The packaging structure according to claim 6, wherein the first reflective lens and the second reflective lens have same size and shape.

8. The packaging structure according to claim 7, wherein an optical coupling adhesive with a first thickness is filled between the optical coupler and the side surface of the first semiconductor chip that is provided with the optical coupling region;
wherein, in a direction perpendicular to the first surface, the first thickness is greater than a cross-sectional height of the second reflective lens.

9. The packaging structure according to claim 1, wherein the packaging structure further comprises at least one second semiconductor chip, the at least one second semiconductor chip is fixed on the first surface of the first semiconductor chip.

10. The packaging structure according to claim 1, wherein when the optical coupler and the at least one second semiconductor chip are simultaneously located on the first surface of the corresponding first semiconductor chip, and in the direction perpendicular to the first surface, the top surface of the optical coupler away from the first surface is flush with a top surface of the at least one second semiconductor chip away from the first surface.

11. A packaging structure manufacturing method, the method comprising:
providing a semiconductor wafer, wherein the semiconductor wafer comprises a plurality of first semiconductor chips, each first semiconductor chip comprises a first surface and a second surface opposite each other, an optical coupling region is disposed on the first surface or the second surface, and an optical coupling interface is provided in the optical coupling region;
for each first semiconductor chip, providing an optical coupler corresponding to the first semiconductor chip, disposing the optical coupler on a side surface of the first semiconductor chip comprising the optical coupling region and correspondingly covering the optical coupling region, wherein the optical coupler corrects external input light by modulating a distance between the optical coupler and the optical coupling interface to couple the external input light to the corresponding optical coupling interface.

12. The packaging structure manufacturing method according to claim 11, wherein, for each first semiconductor chip, providing at least one second semiconductor chip corresponding to the first semiconductor chip, and fixing the at least one second semiconductor chip on the first surface of the first semiconductor chip.

13. The packaging structure manufacturing method according to claim 11 or 12, wherein the optical coupler comprises:
a first substrate layer, and a first reflective lens unit and a second reflective lens unit respectively located on a side surface of the first substrate layer close to the first semiconductor chip and a side surface of the first substrate layer away from the first semiconductor chip, wherein the first substrate layer has light-transmissive properties for light of a predetermined wavelength;
wherein the first reflective lens unit comprises at least one first reflective lens, and the second reflective lens unit comprises at least one second reflective lens; each first reflective lens is configured to reflect light of all wavelengths incident thereon, and each second reflective lens is configured to reflect light of all wavelengths incident thereon; and
the first reflective lens unit is positioned at a first lateral distance position having a first lateral distance from the optical coupling interface of the first semiconductor chip, and the second reflective lens unit is positioned at a second lateral distance position having a second lateral distance from the optical coupling interface of the first semiconductor chip.

14. The packaging structure manufacturing method according to claim 13, wherein the second reflective lens unit is disposed on the side surface of the first substrate layer close to the first semiconductor chip, the first reflective lens unit is disposed on the side surface of the first substrate layer away from the first semiconductor chip, and the first lateral distance is less than the second lateral distance.

15. The packaging structure manufacturing method according to claim 14, wherein:
providing an optical fiber structure, and fixing the optical fiber structure on the side surface of the first substrate layer away from the first semiconductor chip, wherein the optical fiber structure is positioned at a third lateral distance position having a third lateral distance from the first reflective lens unit, and by modulating the first lateral distance, the second lateral distance, and the third lateral distance, the optical coupler causes light from the optical fiber structure to be sequentially reflected by the second reflective lens unit and the first reflective lens unit before entering the optical coupling interface.

16. The packaging structure manufacturing method according to claim 13, wherein the first reflective lens and the second reflective lens have same size and shape.

17. The packaging structure manufacturing method according to claim 16, wherein the step of disposing the optical coupler corresponding to each first semiconductor chip on the side surface of the first semiconductor chip comprising the optical coupling region comprises:
fixing each optical coupler to the side surface of the first semiconductor chip comprising the optical coupling region by an optical coupling adhesive;
wherein the optical coupling adhesive has a first thickness, and in a direction perpendicular to the first surface, the first thickness is greater than a cross-sectional height of the second reflective lens.

18. The packaging structure manufacturing method according to claim 11 or 12, wherein the semiconductor wafer comprises:
a first carrier substrate, wherein the first carrier substrate is temporarily bonded to the second surfaces of the plurality of first semiconductor chips to temporarily support the semiconductor wafer.

19. The packaging structure manufacturing method according to claim 18, wherein after fixing the optical coupler corresponding to each first semiconductor chip on the first semiconductor chip, the method comprises:
forming a plastic encapsulation layer, wherein for each first semiconductor chip, the plastic encapsulation layer encapsulates side surfaces of the optical coupler and covers remains of the first surface and exposes a side surface of the optical coupler away from the first semiconductor chip.

20. The packaging structure manufacturing method according to claim 19, wherein the step of forming the plastic encapsulation layer comprises:
for a case where the optical coupler and at least one second semiconductor chip are simultaneously fixed on the first surface of the corresponding first semiconductor chip, attaching a release film to the side surfaces of the optical coupler and the at least one second semiconductor chip away from the first semiconductor chip; and
forming at least one opening through a thickness of the release film on a side of the release film away from the optical coupler and the at least one second semiconductor chip, and injecting a gel-like plastic encapsulation material into the opening to form the plastic encapsulation layer; wherein a position of the at least one opening corresponds to a gap between adjacent two of the second semiconductor chips and/or a gap between each second semiconductor chip and the optical coupler.

21. The packaging structure manufacturing method according to claim 20, wherein after the plastic encapsulation layer is formed, the method comprises:
removing the release film; and
attaching the side surfaces of each second semiconductor chip and each optical coupler away from the corresponding first semiconductor chip to a dicing tape, and then debonding the first carrier substrate.

22. The packaging structure manufacturing method according to claim 13, wherein a method for manufacturing the optical coupler comprises:
providing a first substrate comprising a first substrate layer, wherein the first substrate comprises a first side and a second side opposite each other;
forming a first photoresist layer on a first side of the first substrate;
performing patterned photolithography etching on the first photoresist layer by a mask process to form a first arc-shaped protrusion structure from remains of the first photoresist layer;
etching the first arc-shaped protrusion structure by an etching process to form a first lens structure on one side of the first substrate layer;
depositing a reflective metal layer on an exposed surface of the first lens structure to form the first reflective lens;
forming a second photoresist layer on the second side of the first substrate;
performing patterned photolithography etching on the second photoresist layer by a mask process to form a second arc-shaped protrusion structure from remains of the second photoresist layer;
etching the second arc-shaped protrusion structure by an etching process to form a second lens structure on another side of the first substrate layer; and
depositing a reflective metal layer on an exposed surface of the second lens structure to form the second reflective lens.
